# EUROPEAN PATENT SPECIFICATION

(11) **EP 3 204 957 B1**
(45) Date of publication and mention of the grant of the patent: **28.06.2023**
(21) Application number: 15801589.1
(22) Date of filing: 13.11.2015
(51) Int. Cl.: H01H 9/04, H01H 36/00, H03K 17/97, H01H 13/06, H01H 19/06, H01H 9/28

(54) **SWITCH APPARATUS FOR ENCLOSURES HAVING ENVIRONMENTAL PROTECTION**
SCHALTERVORRICHTUNG FÜR ANLAGEN MIT UMGEBUNGSSCHUTZ
APPAREIL DE COMMUTATION POUR ENCEINTES COMPRENANT UNE PROTECTION ENVIRONNEMENTALE

(30) Priority: 14.11.2014 US 201414541696
(43) Date of publication of application: 16.08.2017
(73) Proprietor: Fisher Controls International LLC, Marshalltown, IA 50158 (US)
(72) Inventor: AMIRTHASAMY, Stanley, Felix, Ames, IA 50010 (US); LI, Pei, Shenzhen 518101 (CN); BRAMA, Marwan, Singapore 128461 (SG); WINKLER, Richard, J., Marshalltown, IA 50158 (US)
(74) Representative: Swindell & Pearson Limited
(86) International application number: PCT/US2015/060508
(87) International publication number: WO 2016/077660

(56) References cited:
- EP-A2- 0 834 891
- CN-U- 202 434 418
- CN-Y- 2 904 267
- DE-A1- 2 804 952
- DE-A1-102005 063 070
- US-A- 3 448 419
- US-A- 4 366 463

## Description

### FIELD OF THE DISCLOSURE

This patent relates generally to switch apparatus and, more particularly, to switch apparatus for enclosures having environmental protection.

### BACKGROUND

Hand-operated switches are commonly used in process control systems to enable a user to control operation of various equipment implemented within a process control system. Hand-operated switches are often coupled to an enclosure having electrical components and/or circuitry that controls operation of nearby equipment.

Equipment of process control systems may be installed in an industrial environment. In some instances, an enclosure must be compliant with environmental protection safety standards (e.g., explosion-proof rated, dust-proof rated) to be installed in the environment near the corresponding equipment. In such instances, hand-operated switches coupled to the enclosure must be compliant with the environmental protection safety standards.

US4366463 discloses a data entry device durable enough to withstand the rigors of industrial type usage in which the electronic components are isolated from the external environment. The device comprises a molded elastomer keyboard matrix with thin stainless steel keypads. Embedded into the elastomer beneath the keys are small magnets. Solid state Hall-effect switches are mounted at a predetermined distance from the magnets and are separated from them by a magnetically permeable stainless steel sheet which forms part of the enclosure isolating the electronic components from the environment. Depressing one of the keys on the elastomer matrix moves its associated magnet toward the respective Hall-effect device, causing a change in current which may be sensed by other electronic components. Because of the elastomer material, the keys spring back when released.

EP0834891 A2 discloses an autoclavable remote control unit for controlling the operation of a surgical device. The remote control unit has a plurality of Hall effect sensors arranged on a printed circuit board hermetically encased within a polymeric housing molded from an autoclavable material. Each Hall effect sensor may be activated by an associated magnet which is resiliently supported within a panel which can be closed against the housing or hinged away from the housing. In the closed position, the magnets may be momentarily depressed to activate the associated Hall effect sensor to thereby control the operation of a selected function of the surgical device. The disclosure also includes the method of remotely controlling a surgical device by providing at least one non-contiguously activatable switch element in a hermetically sealed housing and activating the element by bringing into its proximity an activating element.

DE102005063070 discloses an operating parameter controlling device for an electrical device. The operating parameter controlling device has an active switching part that is arranged such that an electrical control signal is produced corresponding to movement of a rotary toggle relative to a switching part. The active switching part is attached behind a closed face plate. A passive operating part consists of a rotary toggle that is attached to the switching part on a side of the face plate. The switching part is arranged such that an electrical control signal is produced corresponding to a movement of the rotary toggle relative to the switching part.

DE2804952 discloses an operating device for a magnetically controlled switch, with contacts mounted on a case wall and operated by a magnet placed near them. The switch contacts are mounted in a gas-proof case and can take two positions. The switch contacts are mounted on a case wall. A magnet can be placed near the contacts where it operates them through the case wall, so that the contacts take one of the two positions. They take the other position when the magnet is in its non-working position. The magnet is secured by the aid of a magnet holder, around which a coil is wound.

US 3 448 419 A discloses an apparatus comprising an enclosure defining a first cavity adjacent an exterior surface of a wall and a second cavity adjacent an interior surface of the wall, opposite the exterior surface, the second cavity having environmental protection; a panel coupled to an exterior protrusion of the enclosure and spaced apart from the wall of the enclosure; a hand-operated switch actuator coupled to the panel and spaced apart from the wall, the switch actuator having a head, a stem coupled to an inner surface of the head, and a magnet attached to the stem and positioned within the switch housing of the first cavity; and a magnetically-responsive switch disposed within the second cavity of the enclosure opposite the switch actuator, the magnet to operate the magnetically-responsive switch through the wall when the switch actuator is in a first position.

### SUMMARY

An apparatus according to the invention is defined by the wording of the independent claim 1.

### BRIEF DESCRIPTION OF THE DRAWINGS

FIG. 1 illustrates an example enclosure assembly in accordance with the teachings herein.
FIG. 2 illustrates an enclosure of the enclosure assembly of FIG. 1.
FIG. 3 illustrates the enclosure assembly of FIG. 1 including safety locks.
FIG. 4A is a cross-sectional view of an example hand-operated switch in a deactivated position in accordance with the teachings herein.
FIG. 4B is a cross-sectional view of the hand-operated switch of FIG. 4A in an activated position.
FIG. 5A is a partial cross-sectional view of the enclosure assembly of FIG. 1 including the hand-operated switch of FIGS. 4A and 4B in the deactivated position.
FIG. 5B is a partial cross-sectional view of the enclosure assembly of FIG. 1 including the hand-operated switch of FIGS. 4A and 4B in the activated position.
FIG. 6 is another partial cross-sectional view of the enclosure assembly of FIG. 1.

The figures are not to scale. Instead, to clarify multiple layers and regions, the thicknesses of the layers may be enlarged in the drawings. Wherever possible, the same reference numbers will be used throughout the drawing(s) and accompanying written description to refer to the same or like parts.

### DETAILED DESCRIPTION

Many known enclosures house electrical components and/or circuitry that control operation of equipment within a process control system. Many enclosures include hand-operated switches (e.g., pushbuttons, rotary devices) and/or indicator lights to enable a user (e.g., an operator, an engineer) to control operation of the corresponding equipment. In some instances, the enclosure is installed near the equipment of the process control system. In such instances, the hand-operated switches enable the user to locally initiate operation of the equipment and the indicator lights provide the user with on-site indication of an operation status of the equipment. To enable the enclosure to be installed near the corresponding equipment, many known enclosures are installed in the environment in which the enclosure is installed. For example, because some equipment is installed in hazardous locations, many known enclosures are also installed in hazardous locations.

Many third party agencies (e.g., the National Fire Protection Agency (NFPA), FM Global, Canadian Standards Association (CSA), ATEX, and International Electrotechnical Commission (IEC)) have created environmental protection categories and have set forth standards (e.g., the National Electric Code (NEC) of the NFPA, the International Protection (IP) Code of the IEC, and the Canadian Electrical Code (CEC) of the CSA) for equipment and/or enclosures that are to be installed in hazardous locations. For example, under these standards, hazardous locations are often areas in which flammable materials that have the potential to form an explosive environment are handled. Some types of hazardous locations require enclosures to be intrinsically safe, non-incendive and/or explosion-proof. For example, explosion-proof enclosures must be able to withstand an explosion from within and prevent any spark, flash, ignition, or flame from propagating outside the enclosure in the hazardous environment. An IP66 rating of the IP Code is another environmental protection standard that requires enclosures to prevent any dust, oil, water and/or other hazardous material from entering an interior of the enclosure, for example.

Many known enclosures define an opening and/or hole that is manufactured, cut and/or punched through a wall of the enclosure to receive a hand-operated switch that is operatively coupled to control components disposed within a cavity of the enclosure. In such instances, the hand-operated switch penetrates the surface of the enclosure to couple to the control components disposed within the cavity of the enclosure. To prevent dust, oil, water and/or other hazardous material from entering the cavity via the hole to maintain the environmental protection rating of the enclosure, many known enclosures include a seal (e.g., a gasket, an o-ring) positioned between the hand-operated switch and the wall adjacent the opening in the wall of the enclosure. Because some known hand-operated switches are provided with a gasket and/or o-ring, such known hand-operated switches are rated for environmental protection. In some instances, the seal fails to prevent harmful materials from entering the cavity of the enclosure as a result of the seal (e.g., a seal composed of an elastomeric material) being exposed to incompatible vapors and/or the environment for an extended period of time (e.g., years).

The example hand-operated switches described herein are coupled to a panel of an enclosure assembly without penetrating a wall of an enclosure containing electrical or electronic components. An example hand-operated switch includes a hand-operated switch actuator that is spaced apart from an exterior wall of an enclosure and a magnet that is attached to the hand-operated switch actuator. A magnetically-responsive switch is disposed adjacent an interior surface of the wall opposite the hand-operated switch actuator. To operate the magnetically-responsive switch, the switch actuator moves to change a position of the magnet relative to the magnetically-responsive switch. For example, the magnetically-responsive switch detects the magnet when the hand-operated switch actuator is in a first position (e.g., an activated position) and does not detect the magnet when the hand-operated switch actuator is in a second position (e.g., a deactivated position) different than the first position.

In some examples, the hand-operated switch actuator is coupled to a mounting plate or panel. The panel is coupled to an exterior protrusion or protruding wall of the enclosure and is spaced apart from the wall of the enclosure. For example, the hand-operated switch actuator is received by an aperture defined by the panel and does not penetrate the wall of the enclosure. The hand-operated switch actuator does not penetrate the wall of the enclosure to maintain an environmental protection safety rating (e.g., a hazardous location rating, an explosion-proof rating, an IP66 rating, a dust-proof rating, an ingress-protected rating) of the enclosure.

In some examples, the enclosure assembly includes a second hand-operated switch of which a second hand-operated switch actuator is coupled to the panel and a second magnetically-responsive switch is disposed within the cavity of the enclosure. For example, the second magnetically-responsive switch is magnetically isolated from the hand-operated switch actuator and the magnetically-responsive switch is magnetically isolated from a second magnet attached to the second hand-operated switch actuator.

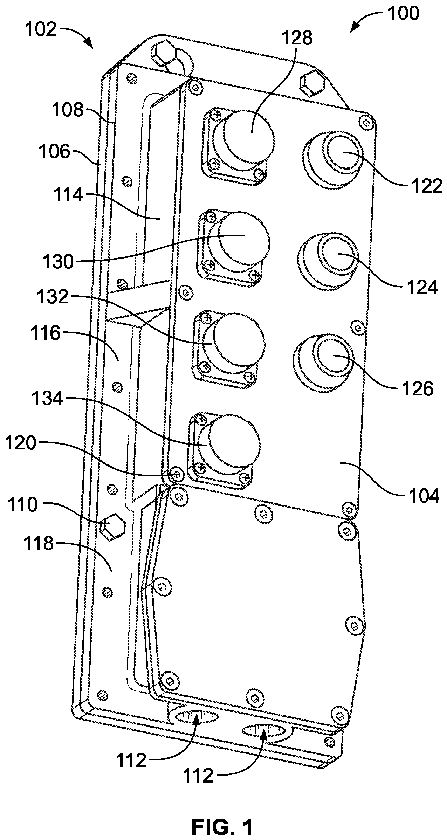

FIG. 1 illustrates an example enclosure assembly 100 in accordance with the teachings herein. The enclosure assembly 100 includes an enclosure or housing 102 and a mounting plate or panel 104 coupled to the enclosure 102. For example, the enclosure assembly 100 satisfies safety standards of an environmental protection rating (e.g., a hazardous location rating, an explosion-proof rating, an IP66 rating of the IP Code, an ingress-protected rating) and, thus, can be installed in the corresponding environment. In some examples, the enclosure assembly 100 is composed of corrosion-resistant material (e.g., stainless steel) to satisfy safety requirements of a corrosive environment.

As illustrated in FIG. 1, a first portion 106 of the enclosure 102 is coupled to a second portion 108 of the enclosure 102 via fasteners 110 (e.g., threaded fasteners). To satisfy the safety requirements, the coupling of the first and second portions 106, 108 prevents materials (e.g., hazardous materials, dust, oil, water, etc.) from entering the enclosure 102 between the first and second portions 106, 108. Further, the enclosure assembly 100 of the illustrated example includes sealed conduits or openings 112 to receive wiring that operatively couples electrical components and/or circuitry of the enclosure assembly 100 with other components of a process control system. For example, the sealed conduits or openings 112 form a seal around received wiring to prevent material from entering the enclosure assembly 100.

As illustrated in FIG. 1, a protruding wall or exterior protrusion 114 protrudes from an exterior surface 116 (e.g., a first side) of a wall 118 of the second portion 108 of the enclosure 102. The panel 104 is coupled to the protruding wall 114 via fasteners 120 (e.g., threaded fasteners). In some examples, a seal is formed between the panel 104 and the protruding wall 114 to prevent materials from traversing between the panel 104 and the enclosure 102. In the illustrated example, hand-operated switches (e.g., pushbuttons, rotary devices) 122, 124, 126 are coupled to the panel 104 of the enclosure assembly 100 that enable a user (e.g., an operator, an engineer) to control equipment of the process control system. For example, each of the hand-operated switches 122, 124, 126 is received by a corresponding opening of the panel 104.

In some examples, indicator lights 128, 130, 132, 134 mounted to the panel 104 indicate the status of equipment operatively coupled to the hand-operated switches 122, 124, 126. As illustrated in FIG. 1, each of the indicator lights 128, 130, 132, 134 is received by a corresponding opening of the panel 104 to enable the indicator light 128, 130, 132, 134 to be operatively coupled to electrical components and/or circuitry disposed within the enclosure assembly 100. An o-ring, seal and/or gasket may be positioned between each indicator light 128, 130, 132, 134 and the corresponding opening to prevent materials from entering the enclosure assembly 100 via the openings. In other examples, the enclosure assembly 100 does not include indicator lights (e.g., the indicator lights 128, 130, 132, 134) coupled to the panel 104.

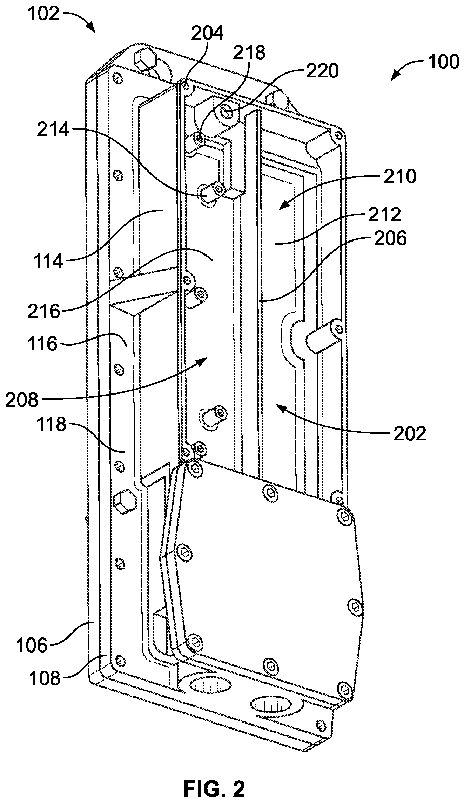

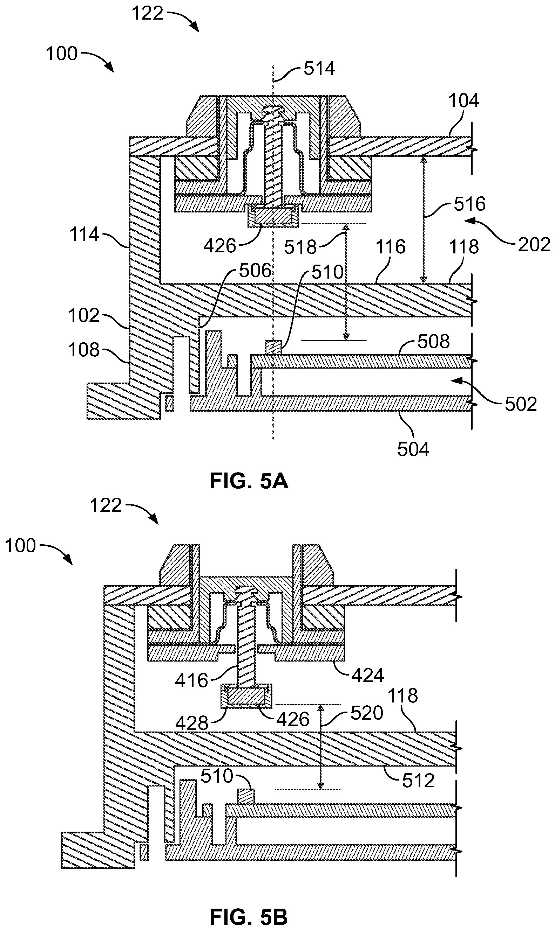

FIG. 2 illustrates the enclosure 102 of the enclosure assembly 100 decoupled from the panel 104 (FIG. 1). In the illustrated example, the wall 118 and the protruding wall 114 of the enclosure 102 define a first cavity 202 of the enclosure assembly 100. The panel 104 is to be coupled to the protruding wall 114 via the fasteners 120 (FIG. 1) to form the first cavity 202 between the enclosure 102 and the panel 104. As illustrated in FIG. 2, the fasteners 120 (FIG. 1) are to be received by bores 204 defined by the protruding wall 114 to couple the panel 104 to the enclosure 102. In some examples, the bores 204 are threaded to receive threaded fasteners. The bores 204 of the illustrated example are blind holes that do not extend to an inner surface (e.g., an interior surface 512 of FIG. 5B) of the enclosure 102. As a result, materials (e.g., hazardous materials, dust, oil, water, etc.) are prevented from traversing into a cavity (e.g., the first cavity 202, a second cavity 502 of FIG. 5A) of the enclosure assembly 100 via the bores 204. In the illustrated example, a dividing wall 206 protrudes from the exterior surface 116 of the wall 118 and divides the first cavity 202 into an indicator housing 208 and a switch housing 210. For example, when the panel 104 is coupled to the protruding wall 114 of the enclosure 102, the panel 104 sealingly engages the dividing wall 206. As a result, the switch housing 210 is isolated from the indicator housing 208 to prevent materials from traversing between the switch housing 210 and the indicator housing 208. In some examples, which are not part of the present invention, in which the enclosure assembly 100 does not include indicator lights (e.g., the indicator lights 128, 130, 132, 134 of FIG. 1), the enclosure 102 does not include the dividing wall 206 to divide the first cavity 202 into the indicator housing 208 and the switch housing 210.

As illustrated in FIG. 2, a first segment 212 of the exterior surface 116 of the wall 118 defines the switch housing 210 and forms a solid surface. For example, no holes, apertures and/or cut-outs are formed by the first segment 212 of the wall 118. As a result, the switch housing 210 is isolated from a cavity (e.g., the second cavity 502 of FIG. 5A) formed within the enclosure 102 between the first and second portions 106, 108 to prevent materials from entering the cavity through the switch housing 210.

In the illustrated example, bosses 214 protrude from a second segment 216 of the exterior surface 116 of the wall 118 that defines the indicator housing 208. Electrical components and/or circuitry operatively coupled to the indicator lights 128, 130, 132, 134 (FIG. 1) are to be coupled to the bosses 214 in the indicator housing 208. For example, the bosses 214 are to receive a board (e.g., a circuit board) on which the electrical components and/or circuitry are located. The bosses 214 define bores 218 to receive fasteners that fasten the board, electrical components and/or circuitry to the bosses 214. In some examples, the bores 218 are threaded to receive threaded fasteners. In the illustrated example, the bores 218 are blind holes that do not extend to an inner surface (e.g., the interior surface 512 of FIG. 5B) of the enclosure 102. As a result, materials are prevented from entering the cavity formed within the enclosure 102 via the bores 218.

As illustrated in FIG. 2, a sealed conduit 220 extends from the exterior surface 116 of the second segment 216 of the wall 118 within the indicator housing 208. The sealed conduit 220 of the illustrated example is integrally formed with the protruding wall 114. The sealed conduit 220 is to receive wiring that operatively couples the electrical components and/or circuitry of the indicator lights 128, 130, 132, 134 with other electrical components and/or circuitry of the enclosure assembly 100. For example, the sealed conduit 220 includes a gasket or a flame-proof seal to form a seal around the received wiring to prevent hazardous materials (e.g., dust, oil, water, etc.) from entering the cavity (e.g., the second cavity 502 of FIG. 5) formed between the first and second portions 106, 108 of the enclosure 102.

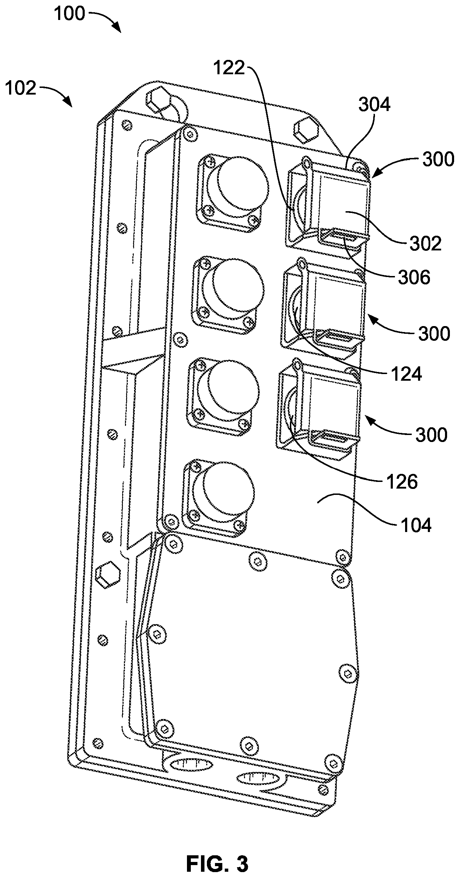

FIG. 3 illustrates the enclosure assembly 100 having a safety lock 300 for each of the hand-operated switches 122, 124, 126. Each safety lock 300 is positioned adjacent one of the hand-operated switches 122, 124, 126 such that the safety lock 300 covers the corresponding hand-operated switch 122, 124, 126 when the safety lock is closed. Each safety lock 300 of the illustrated example incudes a cover 302, a hinge 304, and a slot 306. For example, the cover 302 of the safety lock 300 rotates about the hinge 304 to open and/or close the safety lock 300. For example, when the safety lock 300 is closed, the cover 302 limits and/or prohibits access to the hand-operated switch 122 and, thus, prevents the hand-operated switch 122 from being actuated. The slot 306 is to receive a lock (e.g., a padlock) when the safety lock 300 is closed to prevent the cover 302 from being rotated open. To couple each safety lock 300 to the panel 104 without penetrating the panel 104, each safety lock 300 is clamped between the corresponding hand-operated switch 122, 124, 126 and the panel 104. As a result, the safety locks 300 are mounted to the panel 104 without compromising the seal formed between the panel 104 and the enclosure 102.

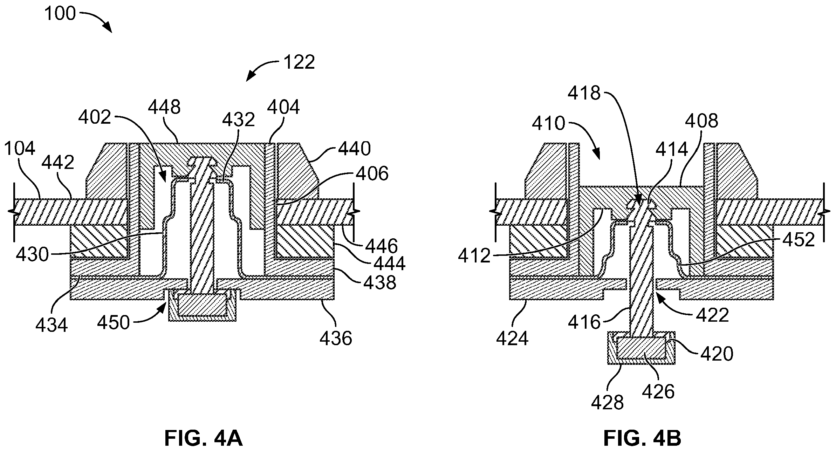

FIGS. 4A and 4B illustrate a partial cross-sectional view of the hand-operated switch 122 coupled to the panel 104 of the enclosure assembly 100. In the illustrated example, the hand-operated switch 122 is a pushbutton. In other examples, the hand-operated switch 122 may be a rotary device or switch. The hand-operated switch 122 of the illustrated example is received by an aperture 402 formed by the panel 104. The hand-operated switch 122 includes an outer housing 404 that extends through the aperture 402 and is positioned adjacent an edge 406 of the panel 104 defining the aperture 402.

As illustrated in FIGS. 4A and 4B, the hand-operated switch 122 includes a head 408 disposed within an opening 410 formed by the outer housing 404. An inner surface 412 of the head 408 is coupled to a first end 414 of a stem 416. The stem 416 is composed of, for example, a magnetic material such as steel. In the illustrated example, the first end 414 of the stem 416 is received by a recess 418 defined by the inner surface 412 of the head 408, and a second end 420 of the stem 416 opposite the first end 414 extends through an aperture 422 formed by a plate 424 of the hand-operated switch 122. The plate 424 is disposed within the first cavity 202 (FIG. 2) between the enclosure 102 (FIG. 1) and the panel 104. As illustrated in FIGS. 4A and 4B, a magnet 426 is coupled to the second end 420 of the stem 416. For example, when the stem 416 is composed of a magnetic material, the magnet 426 is coupled to the stem 416 via a magnetic force. In the illustrated example, a protective cover 428 is coupled to the second end 420 of the stem 416 and covers the magnet 426 to protect the magnet 426 from being exposed to harmful environments and/or from being dislodged from the stem 416.

In the illustrated example, a diaphragm 430 is partially disposed in the opening 410 formed by the outer housing 404 of the hand-operated switch 122. For example, a first end 432 of the diaphragm 430 engages the inner surface 412 of the head 408 adjacent the first end 414 of the stem 416. A second end 434 of the diaphragm 430 opposite the first end 432 is positioned between the outer housing 404 and the plate 424 of the hand-operated switch 122. For example, the second end 434 of the diaphragm 430 is disposed, captured or clamped between an outer section 436 of the plate 424 and a flange 438 of the outer housing 404.

As illustrated in FIGS. 4A and 4B, a lock ring 440 engages the outer housing 404 and an outer surface 442 of the panel 104 to couple, fasten and/or mount the hand-operated switch 122 to the panel 104 of the enclosure assembly 100. In some examples, the lock ring 440 is threadably coupled to the outer housing 404 of the hand-operated switch 122. In the illustrated example, an o-ring, seal and/or gasket 444 is positioned between the flange 438 of the outer housing 404 and an inner surface 446 of the panel 104. The gasket 444 is composed of, for example, an elastomeric material such as rubber. The gasket 444 forms a seal between the hand-operated switch 122 and the panel 104 to reduce and/or prevent materials (e.g., hazardous materials, dust, oil, water, etc.) from entering the first cavity 202 (FIG. 2) of the enclosure assembly 100 via the aperture 402.

FIG. 4A illustrates the hand-operated switch 122 in a deactivated position (e.g., a first position). The diaphragm 430 is in a decompressed or relaxed state when the hand-operated switch 122 is in the deactivated position. As illustrated in FIG. 4A, an outer surface 448 of the head 408 is flush and/or forms a substantially flat surface with the outer housing 404 and the locking ring 440. The second end 420 of the stem 416 engages a groove 450 defined by the plate 424 of the hand-operated switch 122, for example.

FIG. 4B illustrates the hand-operated switch 122 in an activated position (e.g. a second position different than the first position). To transition the hand-operated switch 122 from the deactivated position to the activated position, the head 408 of the hand-operated switch 122 is engaged, pushed and/or urged along a rectilinear path toward the plate 424 of the hand-operated switch 122. Because the stem 416 of the illustrated example is coupled to the head 408, the stem 416 moves along the rectilinear path. As a result, the second end 420 of the stem 416 and, thus, the magnet 426 coupled to the second end 420 disengages and/or moves away from the groove 450 of the plate 424 as the hand-operated switch 122 transitions to the activated position.

As illustrated in FIG. 4B, the diaphragm 430 is deformed and/compressed when the hand-operated switch 122 is in the activated position. The diaphragm 430 provides resilient resistance as the hand-operated switch 122 transitions to the activated position. For example, the diaphragm 430 includes convolutions or ridges 452 that maintain the structure of the diaphragm 430 and/or provide resistance as the diaphragm 430 compresses. In the illustrated example, when the diaphragm 430 is compressed, the diaphragm 430 urges and/or biases the head 408 and, thus, the hand-operated switch 122 to return to the deactivated position. In some examples, the hand-operated switch 122 is a momentary contact switch that enables the diaphragm 430 to return the hand-operated switch 122 to the deactivated position once the applied force is removed. In some examples, the hand-operated switch 122 is a maintained contact switch that enables the hand-operated switch 122 to be maintained in the activated position after the applied force is removed. In such examples, the hand-operated switch 122 returns to the deactivated position after a subsequent force is applied to the head 408.

FIGS. 5A and 5B depict a partial cross-sectional view of the enclosure assembly 100. The wall 118 of the illustrated example separates the first cavity 202 and the second cavity 502. As illustrated in FIGS. 5A and 5B, the first cavity 202 is defined by the panel 104 and the exterior surface 116 of the wall 118, and the second cavity 502 is defined by the first portion 106 (FIG. 1) and the second portion 108 of the enclosure 102. In some examples, the enclosure 102 and, thus, the wall 118 are composed of a non-magnetic material such as stainless steel. In some examples, the enclosure 102 is composed of a corrosion-resistant material that satisfies safety requirements of environments (e.g., hazardous locations) in which the enclosure assembly 100 is to be installed. As illustrated in FIGS. 5A and 5B, the wall 118 defines no openings, holes and/or apertures between the first cavity 202 and the second cavity 502. As a result, any material (e.g., hazardous material, dust, oil, water, etc.) that has entered the first cavity 202 is prevented from entering the second cavity 502.

A circuit board holder 504 (e.g., a potting cup) of the illustrated example is disposed in the second cavity 502 and is coupled to an inner surface 506 of the enclosure 102. A printed circuit board 508 is mounted to and/or in the circuit board holder 504 and a magnetically-responsive switch 510 (e.g., a reed switch, a hall-effect sensor) is coupled to the printed circuit board 508. In some examples, the magnetically-responsive switch 510 is positioned in the second cavity 502 adjacent the interior surface 512 (e.g., a second side opposite the first side) of the wall 118 such that the magnet 426 and the magnetically-responsive switch 510 align along a longitudinal axis 514 of the stem 416 of the hand-operated switch 122.

In the illustrated example, the panel 104 is coupled to the protruding wall 114 of the enclosure 102 such that the panel 104 is spaced apart from the exterior surface 116 (e.g., the first side) of the wall 118 by a distance 516. For example, the distance 516 between the panel 104 and the wall 118 enables the hand-operated switch 122 to be spaced apart from the wall 118 of the enclosure 102 when the hand-operated switch 122 is coupled to the panel 104. As illustrated in FIGS. 5A and 5B, the hand-operated switch 122 is spaced apart from the exterior surface 116 of the wall 118 when the hand-operated switch 122 is in the deactivated position and the activated position, respectively. In other words, no portion of the hand-operated switch 122 (e.g., the stem 416, the plate 424, the magnet 426, the protective cover 428, etc.) engages and/or penetrates the wall 118 of the enclosure 102 in the deactivated position, the activated position and/or any other position.

As illustrated in FIG. 5A, the magnetically-responsive switch 510 and the magnet 426 are separated by a distance 518 in the deactivated position. The distance 518 prevents the magnetically-responsive switch 510 from detecting the magnetic field of the magnet 426 when the hand-operated switch 122 is in the deactivated position (e.g., the first position). The magnet 426 moves along a rectilinear path along the longitudinal axis 514 toward the magnetically-responsive switch 510 as the hand-operated switch 122 transitions from the deactivated position to the activated position.

When the hand-operated switch 122 is in the activated position (e.g., the second position different than the first position), as is illustrated in FIG. 5B, the magnetically-responsive switch 510 and the magnet 426 are separated by a distance 520 that is less than the distance 518. The magnetically-responsive switch 510 detects the magnetic field of the magnet 426 when the magnetically-responsive switch 510 and the magnet 426 are separated by the distance 520. In some examples, because the wall 118 positioned between the magnet 426 and the magnetically-responsive switch 510 is composed of non-magnetic material (e.g., stainless steel), the magnetically-responsive switch 510 detects the magnet 426 through the wall 118 when the hand-operated switch 122 is in the activated position.

The magnet 426 and the magnetically-responsive switch 510 enable the hand-operated switch 122 to be coupled to the enclosure assembly 100 without penetrating the wall 118 of the enclosure 102. Because no opening, hole and/ or aperture is formed in the enclosure 102 between the first and second cavities 202, 502, materials (e.g., hazardous materials, dust, oil, water, etc.) are prevented from entering the second cavity 502 in which electrical components and/or circuitry are disposed. Thus, the hand-operated switch 122 and the magnetically-responsive switch 510 enable the enclosure 102 to isolate the electrical components and/or circuitry from external materials. As a result, the enclosure assembly 100 maintains an environmental protection rating (e.g., a hazardous-location rating, an explosion-proof rating, an IP66 rating of the IP Code, an ingress-protected rating) even if the gasket 444 of the hand-operated switch 122 is absent.

In some examples, the magnetically-responsive switch 510 is a normally-open switch that provides a signal to a process control system when the hand-operated switch 122 is in the activated position and does not provide a signal when the hand-operated switch 122 is in the deactivated position. In some examples, the magnetically-responsive switch 510 is a normally-closed switch that does not provide a signal when the hand-operated switch 122 is in the activated position and provides a signal when the hand-operated switch 122 is in the deactivated position.

In some examples, the magnetically-responsive switch 510 is a reed switch that includes a flexible reed to actuate in response to a magnetic field. When the magnet 426 moves relative to the reed switch, the magnetic field of the magnet 426 causes the flexible reed to move relative to the other reed. The reeds contact each other and complete an electrical circuit when the magnet 426 is within a predetermined distance of the reed switch. For example, the reed switch of the magnetically-responsive switch 510 actuates as the hand-operated switch 122 transitions between the deactivated position and the activated position. Because the reeds contact each other when the hand-operated switch 122 is in the activated position, the reed switch of the magnetically-responsive switch 510 enables the circuit to be completed without electrical power being supplied to the pushbutton and/or the magnetically-responsive switch 510. As a result, no electrical components and/or circuits are disposed in the first cavity 202 to couple to the magnetically-responsive switch 510.

In some examples, the magnetically-responsive switch 510 is a hall-effect sensor. For example, a hall-effect sensor is a transducer that varies output voltage in response to a magnetic field and includes circuitry that enables the hall-effect sensor to act as a switch. Because the magnetic field detected by the hall-effect sensor of the magnetically-responsive switch 510 varies as the magnet 426 of the hand-operated switch 122 moves relative to the magnetically-responsive switch 510, the output voltage of the hall-effect sensor varies as the hand-operated switch 122 actuates between the activated and deactivated positions. In some examples, the magnetically-responsive switch 510 includes electrical components and/or circuitry to enable the hall-effect sensor of the magnetically-responsive switch 510 to provide a signal to the process control system.

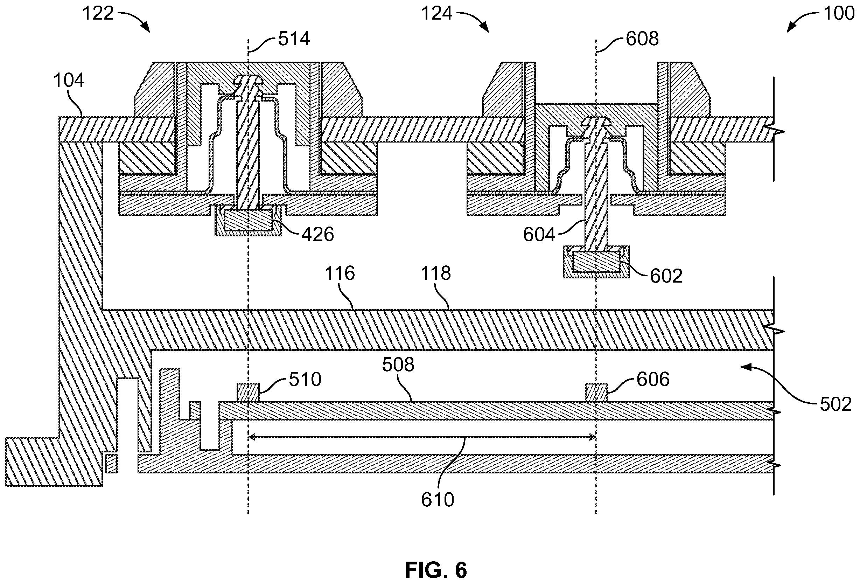

FIG. 6 illustrates another cross-sectional view of the enclosure assembly 100. In the illustrated example, the hand-operated switches 122, 124 are pushbuttons. For example, the hand-operated switch 124 includes components that are substantially similar or identical to the components of the hand-operated switch 122 described above. In other examples, the hand-operated switch 122 and/or the hand-operated switch 124 may be a rotary device or switch.

As illustrated in FIG. 6, the hand-operated switches 122, 124 are coupled to the panel 104 of the enclosure assembly 100. In the illustrated example, the hand-operated switch 122 is in the deactivated position and the hand-operated switch 124 is in an activated position. Because the panel 104 is spaced apart from the exterior surface 116 of the wall 118, neither the hand-operated switch 122 nor the hand-operated switch 124 engages and/or penetrates the wall 118 of the enclosure 102 in the activated position, the deactivated position and/or any other position. In the illustrated example, a magnet 602 is coupled to a stem 604 of the hand-operated switch 124, and a magnetically-responsive switch 606 that is to detect a field of the magnet 602 is disposed in the second cavity 502. For example, the magnetically-responsive switch 606 is positioned on the printed circuit board 508 such that the magnetically-responsive switch 606 and the magnet 602 align along a longitudinal axis 608 of the stem 604 of the hand-operated switch 124.

As illustrated in FIG. 6, the longitudinal axis 514 of the hand-operated switch 122 is separated from the longitudinal axis 608 of the hand-operated switch 124 by a distance 610. For example, the distance 610 between the hand-operated switch 122 and the hand-operated switch 124 prevents the magnetically-responsive switch 510 from detecting the magnet 602 of the hand-operated switch 124 in the activated position, the deactivated position and/or any other position. Further, the distance 610 between the hand-operated switch 122 and the hand-operated switch 124 prevents the magnetically-responsive switch 606 from detecting the magnet 426 of the hand-operated switch 122 in the activated position, the deactivated position and/or any other position. Thus, the distance 610 between the hand-operated switch 122 and the hand-operated switch 124 prevents the hand-operated switch 122 from interfering with operation of the magnetically responsive switch 606 and prevents the hand-operated switch 124 from interfering with operation of the magnetically-responsive switch 510.

Further, the magnetically-responsive switches 510, 606 of the illustrated example are spaced apart from other sources (e.g., a motor). For example, the magnetically-responsive switches 510, 606 are positioned to prevent the magnetically-responsive switches 510, 606 from detecting magnetic and/or electromagnetic signals of the other sources (e.g., signals not of the corresponding magnets 426, 602). In other words, the magnetically-responsive switch 510 is positioned such that the magnetically-responsive switch 510 can only detect the magnetic field of the magnet 426, and the magnetically-responsive switch 606 is positioned such that the magnetically-responsive switch 606 can only detect the magnetic field of the magnet 602.

## Claims

1. An apparatus (100) comprising:
an enclosure (102) defining a first cavity (202) adjacent an exterior surface (116) of a wall (118) and a second cavity (502) adjacent an interior surface (512) of the wall (118), opposite the exterior surface (116), the second cavity (502) having environmental protection;
a dividing wall (206) protruding from the exterior surface (116) of the wall (118), the dividing wall (206) dividing the first cavity (202) into an indicator housing (208) and a switch housing (210);
a panel (104) coupled to an exterior protrusion (114) of the enclosure (102) and spaced apart from the wall (118) of the enclosure (102);
a hand-operated switch actuator (122) coupled to the panel (104) and spaced apart from the wall (118), the switch actuator (122) having a head (408), a stem (416) coupled to an inner surface (412) of the head (408), and a magnet (426) attached to the stem (416) and positioned within the switch housing (210) of the first cavity (202);
and
a magnetically-responsive switch (510) disposed within the second cavity (502) of the enclosure (102) opposite the switch actuator (122), the magnet (426) to operate the magnetically-responsive switch (510) through the wall (118) when the switch actuator (122) is in a first position.

2. The apparatus (100) of claim 1, wherein the magnet (426) does not operate the magnetically-responsive switch (510) when the switch actuator (122) is actuated to a second position different than the first position.

3. The apparatus (100) of any of the preceding claims, wherein, to maintain at least one of an explosion-proof rating, a dust-proof rating, or an ingress-protected rating of the enclosure (102), the switch actuator (122) does not penetrate the wall (118) of the enclosure (102).

4. The apparatus (100) of any of the preceding claims, wherein the enclosure (102) is composed of a non-magnetic material.

5. The apparatus (100) of any of the preceding claims, wherein the exterior protrusion (114) protrudes from the exterior surface (116) of the wall (118) of the enclosure (102).

6. The apparatus (100) of any of the preceding claims, wherein the switch actuator (122) is received by an aperture (402) defined by the panel (104).

7. The apparatus (100) of any of the preceding claims, further comprising a safety lock (300) coupled to the enclosure (102) to limit access to the switch actuator (122).

8. The apparatus (100) of any of the preceding claims, further comprising a second switch actuator (124) coupled to the panel (104) and a second magnetically-responsive switch (606) disposed within the second cavity (502) to detect the second switch actuator (124).

9. The apparatus (100) of claim 8, wherein the second magnetically-responsive switch (606) is magnetically isolated from the switch actuator (122) and the magnetically-responsive switch (510) is magnetically isolated from a second magnet (602) of the second switch actuator (124).

10. The apparatus (100) of any of the preceding claims, wherein movement of the switch actuator (122) is to change a position of the magnet (426) to operate the magnetically-responsive switch (510).

11. The apparatus (100) of any of the preceding claims, wherein the switch actuator (122) is a pushbutton or a rotary device.

12. The apparatus (100) of any of the preceding claims, wherein the magnetically-responsive switch (510) is a reed switch or a hall-effect sensor.

13. The apparatus (100) of any of the preceding claims, comprising an indicator light (128) coupled to the panel (104) and extending into the first cavity (202).

14. The apparatus (100) of claim 13, wherein comprising a dividing wall (206) extending from the exterior surface (116) of the wall (118) and dividing the first cavity (202) into a switch housing (210) and an indicator housing (208), wherein the magnet (426) of the switch actuator (122) is disposed in the switch housing (210) and the indicator light (128) extends into the indicator housing (208).

15. The apparatus (100) of claim 14, comprising a sealed conduit (220) positioned in the indicator housing (208) to receive wiring coupled to the indicator light (128).

## Patentansprüche

1. Vorrichtung (100), umfassend:
ein Gehäuse (102), das einen ersten Hohlraum (202) angrenzend an eine Außenfläche (116) einer Wand (118) und einen zweiten Hohlraum (502) angrenzend an eine Innenfläche (512) der Wand (118) gegenüber der Außenfläche (116) definiert, wobei der zweite Hohlraum (502) einen Umgebungsschutz aufweist;
eine Trennwand (206), die von der Außenfläche (116) der Wand (118) hervorsteht, wobei die Trennwand (206) den ersten Hohlraum (202) in ein Anzeigegehäuse (208) und ein Schaltergehäuse (210) unterteilt;
eine Platte (104), die mit einem äußeren Vorsprung (114) des Gehäuses (102) gekoppelt und von der Wand (118) des Gehäuses (102) beabstandet ist;
einen handbetätigten Schalteraktuator (122), der mit der Platte (104) gekoppelt und von der Wand (118) beabstandet ist, wobei der Schalteraktuator (122) einen Kopf (408), einen mit einer Innenfläche (412) des Kopfes (408) gekoppelten Schaft (416) und einen Magneten (426) aufweist, der an dem Schaft (416) angebracht und innerhalb des Schaltergehäuses (210) des ersten Hohlraums (202) positioniert ist; und
einen magnetisch ansprechenden Schalter (510), der innerhalb des zweiten Hohlraums (502) des Gehäuses (102) gegenüber dem Schalteraktuator (122) angeordnet ist, wobei der Magnet (426) den magnetisch ansprechenden Schalter (510) durch die Wand (118) betätigt, wenn der Schalteraktuator (122) in einer ersten Position ist.

2. Vorrichtung (100) nach Anspruch 1, wobei der Magnet (426) den magnetisch ansprechenden Schalter (510) nicht betätigt, wenn der Schalteraktuator (122) in eine zweite Stellung betätigt wird, die sich von der ersten Stellung unterscheidet.

3. Vorrichtung (100) nach einem der vorherigen Ansprüche, wobei der Schalteraktuator (122) die Wand (118) des Gehäuses (102) nicht durchdringt, um mindestens eine von einer explosionsgeschützten Einstufung, staubgeschützten Einstufung oder eindringgeschützten Einstufung des Gehäuses (102) aufrechtzuerhalten.

4. Vorrichtung (100) nach einem der vorherigen Ansprüche, wobei das Gehäuse (102) aus einem nicht-magnetischen Material besteht.

5. Vorrichtung (100) nach einem der vorherigen Ansprüche, wobei der äußere Vorsprung (114) von der Außenfläche (116) der Wand (118) des Gehäuses (102) hervorsteht.

6. Vorrichtung (100) nach einem der vorherigen Ansprüche, wobei der Schalteraktuator (122) von einer Öffnung (402) aufgenommen wird, die durch die Platte (104) definiert ist.

7. Vorrichtung (100) nach einem der vorigen Ansprüche, ferner umfassend ein Sicherheitsschloss (300), das mit dem Gehäuse (102) gekoppelt ist, um einen Zugang zu dem Schalteraktuator (122) zu begrenzen.

8. Die Vorrichtung (100) nach einem der vorherigen Ansprüche, ferner umfassend einen zweiten Schalteraktuator (124), der mit der Platte (104) gekoppelt ist, und einen zweiten magnetisch ansprechenden Schalter (606), der in dem zweiten Hohlraum (502) angeordnet ist, um den zweiten Schalteraktuator (124) zu erfassen.

9. Vorrichtung (100) nach Anspruch 8, wobei der zweite magnetisch ansprechende Schalter (606) von dem Schalteraktuator (122) magnetisch isoliert ist und der magnetisch ansprechende Schalter (510) von einem zweiten Magneten (602) des zweiten Schalteraktuators (124) magnetisch isoliert ist.

10. Vorrichtung (100) nach einem der vorherigen Ansprüche, wobei eine Bewegung des Schalteraktuators (122) dazu dient, eine Position des Magneten (426) zu ändern, um den magnetisch ansprechenden Schalter (510) zu betätigen.

11. Vorrichtung (100) nach einem der vorherigen Ansprüche, wobei der Schalteraktuator (122) eine Drucktaste oder ein Drehapparat ist.

12. Vorrichtung (100) nach einem der vorherigen Ansprüche, wobei der magnetisch ansprechende Schalter (510) ein Reed-Schalter oder ein Halleffektsensor ist.

13. Vorrichtung (100) nach einem der vorherigen Ansprüche, umfassend eine Anzeigelampe (128), die mit der Platte (104) gekoppelt ist und sich in den ersten Hohlraum (202) erstreckt.

14. Vorrichtung (100) nach Anspruch 13, wobei umfassend eine Trennwand (206), die sich von der Außenfläche (116) der Wand (118) erstreckt und den ersten Hohlraum (202) in ein Schaltergehäuse (210) und ein Anzeigegehäuse (208) unterteilt, wobei der Magnet (426) des Schalteraktuators (122) in dem Schaltergehäuse (210) angeordnet ist und sich die Anzeigelampe (128) in das Anzeigegehäuse (208) erstreckt.

15. Vorrichtung (100) nach Anspruch 14, umfassen eine abgedichtete Leitung (220), die in dem Anzeigegehäuse (208) positioniert ist, um eine mit der Anzeigeleuchte (128) gekoppelte Verdrahtung aufzunehmen.

## Revendications

1. Appareil (100) comprenant :
une enceinte (102) définissant une première cavité (202) adjacente à une surface extérieure (116) d'une paroi (118) et une seconde cavité (502) adjacente à une surface intérieure (512) de la paroi (118), opposée à la surface extérieure (116), la seconde cavité (502) ayant une protection environnementale ;
une paroi de séparation (206) faisant saillie de la surface extérieure (116) de la paroi (118), la paroi de séparation (206) divisant la première cavité (202) en un boîtier d'indicateur (208) et un boîtier de commutateur (210) ;
un panneau (104) couplé à une saillie extérieure (114) de l'enceinte (102) et espacé de la paroi (118) de l'enceinte (102) ;
un actionneur de commutateur manuel (122) couplé au panneau (104) et espacé de la paroi (118), l'actionneur de commutateur (122) ayant une tête (408), une tige (416) couplée à une surface intérieure (412) de la tête (408), et un aimant (426) fixé à la tige (416) et positionné à l'intérieur du boîtier de commutateur (210) de la première cavité (202) ; et
un commutateur magnétiquement sensible (510) disposé à l'intérieur de la seconde cavité (502) de l'enceinte (102) opposé à l'actionneur de commutateur (122), l'aimant (426) permettant de faire fonctionner le commutateur magnétiquement sensible (510) à travers la paroi (118) lorsque l'actionneur de commutateur (122) est dans une première position.

2. Appareil (100) selon la revendication 1, dans lequel l'aimant (426) ne fait pas fonctionner le commutateur magnétiquement sensible (510) lorsque l'actionneur de commutateur (122) est actionné dans une seconde position différente de la première position.

3. Appareil (100) selon l'une quelconque des revendications précédentes, dans lequel, pour conserver au moins l'un d'un indice de protection contre la déflagration, un indice de protection contre la poussière ou un indice de protection contre l'intrusion de l'enceinte (102), l'actionneur de commutateur (122) ne pénètre pas dans la paroi (118) de l'enceinte (102).

4. Appareil (100) selon l'une quelconque des revendications précédentes, dans lequel l'enceinte (102) est composée d'un matériau non magnétique.

5. Appareil (100) selon l'une quelconque des revendications précédentes, dans lequel la saillie extérieure (114) fait saillie de la surface extérieure (116) de la paroi (118) de l'enceinte (102).

6. Appareil (100) selon l'une quelconque des revendications précédentes, dans lequel l'actionneur de commutateur (122) est reçu par une ouverture (402) définie par le panneau (104).

7. Appareil (100) selon l'une quelconque des revendications précédentes, comprenant en outre un verrou de sécurité (300) couplé à l'enceinte (102) pour limiter l'accès à l'actionneur de commutateur (122).

8. Appareil (100) selon l'une quelconque des revendications précédentes, comprenant en outre un second actionneur de commutateur (124) couplé au panneau (104) et un second commutateur magnétiquement sensible (606) disposé à l'intérieur de la seconde cavité (502) pour détecter le second actionneur de commutateur (124).

9. Appareil (100) selon la revendication 8, dans lequel le second commutateur magnétiquement sensible (606) est magnétiquement isolé de l'actionneur de commutateur (122) et le commutateur magnétiquement sensible (510) est magnétiquement isolé d'un second aimant (602) du second actionneur de commutateur (124).

10. Appareil (100) selon l'une quelconque des revendications précédentes, dans lequel le mouvement de l'actionneur de commutateur (122) consiste à modifier une position de l'aimant (426) pour actionner le commutateur magnétiquement sensible (510).

11. Appareil (100) selon l'une quelconque des revendications précédentes, dans lequel l'actionneur de commutateur (122) est un bouton poussoir ou un dispositif rotatif.

12. Appareil (100) selon l'une quelconque des revendications précédentes, dans lequel le commutateur magnétiquement sensible (510) est un commutateur à lames souples ou un capteur à effet Hall.

13. Appareil (100) selon l'une quelconque des revendications précédentes, comprenant un voyant lumineux (128) couplé au panneau (104) et s'étendant dans la première cavité (202).

14. Appareil (100) selon la revendication 13, comprenant une paroi de séparation (206) s'étendant depuis la surface extérieure (116) de la paroi (118) et divisant la première cavité (202) en un boîtier de commutateur (210) et un boîtier d'indicateur (208), dans lequel l'aimant (426) de l'actionneur de commutateur (122) est disposé dans le boîtier de commutateur (210) et le voyant lumineux (128) s'étend dans le boîtier d'indicateur (208).

15. Appareil (100) selon la revendication 14, comprenant un conduit étanche (220) positionné dans le boîtier d'indicateur (208) pour recevoir un câblage couplé au voyant lumineux (128).
